# EUROPÄISCHE PATENTSCHRIFT

(11) **EP 0 609 489 B1**
(45) Veröffentlichungstag und Bekanntmachung des Hinweises auf die Patenterteilung: **31.07.1996**
(21) Anmeldenummer: 93114245.9
(22) Anmeldetag: 06.09.1993
(51) Int. Cl.: C23C 14/04, C23C 14/56, G11B 5/855, G11B 7/26

(54) **Vorrichtung zum Anbringen und/oder Entfernen einer Maske an einem Substrat**
Apparatus for attaching and/or removing a mask on a substrate
Dispositif pour appliquer un masque sur un substrat et/ou pour l'enlever

(30) Priorität: 02.02.1993 DE 4302851
(43) Veröffentlichungstag der Anmeldung: 10.08.1994
(73) Patentinhaber: LEYBOLD AKTIENGESELLSCHAFT, D-63450 Hanau (DE)
(72) Erfinder: Zejda, Jaroslav, D-63517 Rodenbach (DE)

(56) Entgegenhaltungen:
- EP-A- 0 220 685
- DE-A- 3 604 698
- US-A- 4 943 363

## Beschreibung

Die Erfindung betrifft eine Vorrichtung zum Anbringen und/oder Entfernen einer Maske an einem vorzugsweise kreisringförmigen flachen Substrat in einer Vakuum-Beschichtungsanlage, mit zwei in zueinander parallelen Ebenen angeordneten Kammern, die über eine gemeinsame Öffnung miteinander verbunden sind.

Es ist eine Vorrichtung zum Beschichten von flachen Substraten beispielsweise von Compact Discs bekannt (US 4.548.699), mit einer flachen kreiszylindrischen Transportkammer und einem in dieser Transportkammer drehbar gelagerten kreisscheibenförmigen Substrathalter der das Substrat nach dem Einschleusen in die Transportkammer von der einen Bearbeitungsstation zur nächsten Bearbeitungsstation transportiert. Der scheibenförmige Substrathalter ist auf der Welle, auf der er drehbar gelagert ist, zusätzliche auch in Richtung der Rotationsachse motorisch verschiebbar, so daß die auf dem Substratteller angeordneten Substrate nicht nur auf einer Kreisbahn von Station zu Station transportierbar sind, sondern auch bis unmittelbar vor die Bearbeitungsstation bzw. bis vor die Ein- und Ausschleusöffnung in der Kammerwand bewegbar sind.

Weiterhin ist eine Vakuumbeschichtungsanlage zum Aufdampfen dünner Schichten auf Substrate, mit einer Eintrittskammer, weiteren Kammern zur Behandlung bzw. Beschichung der Substrate und mit einer in einer Austrittskammer bekannt (DE 24 54 544 C4), die mit einer in einer evakuierbaren Hauptkammer angeordneten Fördereinrichtung zum Transport der Substrate durch die Kammern versehen ist, wobei Abdichteinrichtungen zur zeitweisen Abdichtung zwischen den genannten Kammern und der Hauptkammer vorgesehen sind, wobei die Fördereinrichtung um eine gemeinsame Achse herum angeordnete und um diese schwenkbare Rahmen für die Aufnahme des zu beschichtenden Gutes aufweist, wobei in wenigstens zwei Behandlungspositionen, nämlich einer Ein- und Austrittsposition und einer Aufdampfposition, ein solcher Rahmen selbst einen Teil der Wand einer Behandlungskammer, nämlich der Ein- und Austrittskammer und einer Aufdampfkammer bildet und wobei in mindestens einer dieser Behandlungspositionen eine bewegliche Ventilplatte zum Absperren einer Stirnseite des den einen Teil der Behandlungskammer bildenden Rahmens vorgesehen ist.

Schließlich ist eine Vakuumbeschichtungsanlage bekannt (US 3.838.028), bei der zusätzlich zu der kreiszylindrischen Transportkammer für den kreischeibenförmigen drehbaren Substratträger noch eine zweite Kammer zum Ein- und Ausschleusen der Substrate vorgesehen ist, die über eine Öffnung mit der Transportkammer in Verbindung steht.

Die bekannten Vakuumbeschichtungsanlagen haben sämtlich den Nachteil, daß das Anbringen von Masken auf den Substraten, die ein vollständiges Beschichten der Oberflächen der Substrate verhindern sollen, nur außerhalb der Vakuumkammer bzw. Transportkammer möglich ist. Dies hat jedoch insbesondere den Nachteil, daß die Masken zum teilweise Abdecken der Substrate schon nach wenigen Beschichtungsvorgängen unbrauchbar werden, da sie nach dem Ausschleusen der beschichteten Substrate mit dem Luftsauerstoff in Verbindung geraten, was zu einer Flitter bildenden Schicht auf der Oberfläche der Maske führt.

Der vorliegenden Erfindung liegt nun die Aufgabe zugrunde, eine Vorrichtung der eingangs genannten Art zu schaffen, die eine zuverlässige, vollständig automatische Maskierung, insbesondere von magnetooptischen Disks ermöglicht, wobei diese außerordentlich präzise und zentrierte Abdeckung der Substrate innerhalb der Vakuumkammer erfolgen soll.

Erfindungsgemäß wird diese Aufgabe dadurch gelöst, daß in jeder der beiden Kammern ein Substrattransportglied, beispielsweise eine Transportkelle, mit jeweils einer Substrataufnahme, schwenkbar gelagert ist, wobei die Schwenkachsen dieser beiden Substrattransportglieder parallel zueinander angeordnet sind und einen Abstand ihrer Schwenkachsen zueinander aufweisen, der zumindest in einer Position das Überdecken von zwei Substrataufnahmen gestattet, wobei im Bereich dieser Überdeckung oberhalb der einen und unterhalb der anderen Substrataufnahme jeweils ein Stößel angeordnet ist, die beide parallel der Schwenkachse längsverschiebbar sind und mit Masken zusammenwirken, die mit einem Magneten korrespondieren der an der Substrataufnahme des einen Substrattransportgliedes befestigt ist, wobei die beiden Stößel die Zuführung bzw. die Abnahme und den Tranport einer Maske von einer Bereitstellungsposition in die Position an der Substrataufnahme oder umgekehrt bewirken.

Weitere Einzelheiten und Merkmale sind in den Patentansprüchen näher beschrieben und gekennzeichnet.

Die Erfindung läßt die verschiedensten Ausführungsmöglichkeiten zu; eine davon ist in der anhängenden Zeichnung, die einen Teil-Längsschnitt durch die Vorrichtung zeigt, näher dargestellt.

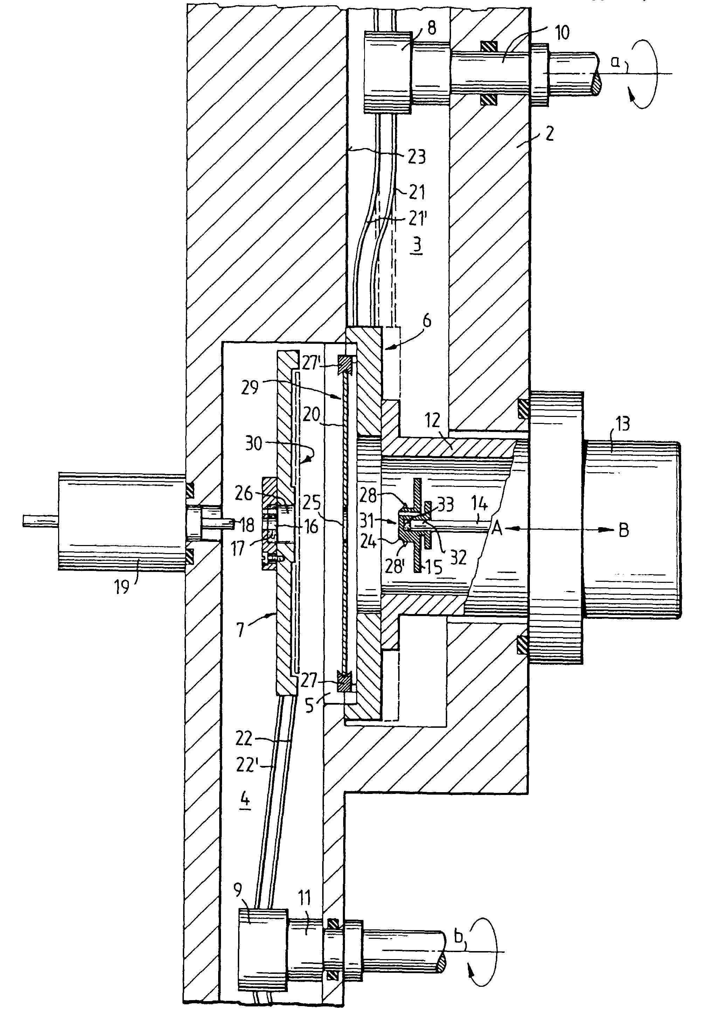

Die Vorrichtung besteht im Wesentlichen aus einem druckdichten Gehäuse 2, das zwei in zueinander parallelen Ebenen angeordnete Kammern 3, 4 aufweist, die über eine Öffnung 5 miteinander verbunden sind, wobei jede der beiden Kammern 3, 4 als kreiszylindrischer Hohlraum ausgebildet ist und wobei die Längsachsen der beiden kreiszylindrischen Kammer 3, 4 parallel zueinander, jedoch gegeneinander versetzt angeordnet sind. Sowohl in der Kammer 3, als auch in der benachbarten Kammer 4 sind Transportkellen 6, 7 angeordnet, die jeweils in der Art von Radspeichen fest mit Naben 8, 9 verbunden sind, die auf Antriebswellen 10, 11 sitzen, die von nicht näher dargestellten Motoren antreibbar sind. Während in der Kammer 4 Transportkellen rotieren, die Substrate 20 auf einer Kreisbahn von einer Behandlungsstation zur nächsten Behandlungsstation transportieren, bewegen die Transportkellen 6 die Substrate von einer Ein-/Ausschleusstation (nicht dargestellt) zur dargestellten Übergabestation und umgekehrt (von der Übergabestation zur Ein-/Ausgabestation). Im Bereich der Öffnung 5, die die beiden Kammern 3, 4 miteinander verbindet, ist eine Druckhülse 12 vorgesehen, die in einer Antriebseinheit 13 gehalten und geführt ist und die eine Bewegung der Druckhülse 12 in Pfeilrichtung A-B gestattet.In der Antriebseinheit 13 ist weiterhin ein Stößel 14 gelagert, der ebenfalls in Pfeilrichtung A-B motorisch bewegbar ist und der mit einer Maske 15 korrespondiert, wobei die Längsachse des Stößels 14 mit der zentralen Aufnahmebohrung 16 eines Ringmagneten 17 fluchtet, wenn sich die Transportkelle 7 in der in der Zeichnung dargestellten Position befindet. Mit dem Stößel 14 fluchtet außerdem ein zweiter Stößel 18 der in einer Motor-Einheit 19 gelagert ist, die auf dem Gehäuse 2 der Antriebseinheit 13 gegenüberliegend angeordnet ist und die ebenfalls eine Bewegung des Stößels 18 in Richtung A-B gestattet.

In der Zeichnung sind die Stellungen der Transportkellen 6, 7 so dargestellt, daß die Übergabe eines Substrats 20 von der Transporkelle 6 zur Transportkelle 7 erfolgen kann (derartige Transportkellen und ihre Antriebseinheiten sind in allen Einzelheiten näher beschrieben und dargestellt in der DE 39 12 295 A1).

Zum Zwecke der Übergabe des Substrats 20 an die Transportkelle 7 wird zunächst die Transportkelle 6 in Pfeilrichtung A von der Druckhülse 12 aus einer mittleren, strichliert angedeuteten Position, gegen die Kraft der Federarme 21, 21',.. an die Innenwand 23 gedrückt, wobei gleichzeitig der Antrieb der Welle 10 blockiert wird. Danach bewegt sich der Stößel 14 in richtung A so weit nach links auf die in der dargestellten Position blokkierten Transportkelle 6 zu, bis das Kopfteil 24 der Maske 15 in die zentrale Öffnung 25 des Substrats 20 eingetaucht ist und danach weiter unter Mitnahme des Substrats 20, bis das Kopfteil 24 am Magneten 17 anliegt und von diesem in dieser Stellung in der Bohrung 26 gehalten wird. Um die Mitnahme des Substrats 20 von der dargestelltn Position in die strichliert eingezeichnete Position an der Transportkelle 7 zu ermöglichen, schwenken gleichzeitig die Halteklauen 27, 27',... radial nach außen, so daß sie das Substrat 20 freigeben (Ein hierfür geeigneter Mechanismus und Antrieb ist an der Transportkelle 6 angeordnet; jedoch nicht näher beschrieben und dargestellt). Die Maske 15 ist nun in der Bohrung 26 so zentriert und am Magneten 17 gehalten, daß der Stößel 14 in Pfeilrichtung B in seine Ausgangsposition zurückbewegt werden kann, wobei gleichzeitig die Transportkelle 7 um die Rotationsachse b weiterbewegt werden kann, um das Substrat 20 zur ersten Behandlungsstation zu transportieren. Mit der Weiterbewegung bzw. Schwenkbewegung der dargestellten Transportkelle 7 wird eine weitere, dieser benachbarten Transportkelle 7 in die Position geschwenkt, in der sich die dargestellten Transportkelle 7 vorher befand, so daß eine Übergabe des von dieser gehaltenen Substrats 20 an die gegenüberliegend verharrenden Transportkelle 6' erfolgen kann. Zu diesem Zweck bewegt sich der Stößel 18 nun, angetrieben vom Motor 19, in Pfeilrichtung B bis sein vorderes Ende auf den Kopf der Maske 15 stößt, diese Maske vom Magneten 17 an der Transportkelle 7 abreißt und dann die Maske 15 zusammen mit dem Substrat 20 in Pfeilrichtung B bis in die Ebene der Halteklauen 27, 27' transportiert. Da das Kopfteil 24 jeder Maske 15 mit Haltenoppen 28, 28',... ausgestattet ist, bleibt dabei die Maske 15 solange am Substrat 20 haften bzw. mit dieser formschlüssig verbunden, bis eine weitere Bewegung in Pfeilrichtung B von den Halteklauen 27, 27',.. verhindert wird; die Maske wird danach vom Stößel 18 allein weiterbewegt, bis sie fest auf dem gegenüberliegenden Stößel 14 aufsitzt (wie dies die Zeichnung zeigt). Das Substrat 20 kann nun von der Transportkelle ohne die Maske 15 nach einer Rückbewegung der Druckhülse 12 in die (nicht näher dargestellten) Ein-/Ausschleus-Position verschwenkt werden.

### Auflistung der Einzelteile

- 2: druckdichtes Gehäuse
- 3: Kammer
- 4: Kammer
- 5: Öffnung
- 6: Transportkelle
- 7: Transportkelle
- 8: Nabe
- 9: Nabe
- 10: Antriebswelle
- 11: Antriebswelle
- 12: Druckhülse
- 13: Antriebseinheit
- 14: Stößel
- 15: Maske
- 16: Aufnahmebohrung
- 17: Ringmagnet
- 18: Stößel
- 19: Motor-Einheit
- 20: Substrat
- 21, 21': Federarm
- 22, 22': Federarm
- 23: Seitenwand der Kammer 3
- 24: Kopfteil
- 25: Öffnung
- 26.: Bohrung
- 27, 27': Halteklaue
- 28, 28': Haltenoppen, Nase
- 29: Substrataufnahme
- 30: Substrataufnahme
- 31: Bohrung
- 32: Sacklochbohrung
- 33: Magnet

## Patentansprüche

1. Vorrichtung zum Anbringen und/oder Entfernen einer Maske an einem vorzugsweise kreisringförmigen, flachen Substrat (7) in einer Vakuum-Beschichtungsanlage mit zwei in zueinander parallelen Ebenen angeordneten Kammern (3,4) die über eine gemeinsame Öffnung (5) miteinander verbunden sind, wobei in jeder der beiden Kammern (3,4) ein Substrattransportglied, beispielsweise eine Transportkelle (6,7) mit jeweils einer Substrataufnahme (29, 30), schwenkbar gelagert ist, wobei die Schwenkachsen (a,b) dieser beiden Substrattransportglieder parallel zu einander angeordnet sind und einen Abstand ihrer Schwenkachsen zueinander aufweisen, der zumindest in einer Position das Überdecken von zwei Substrataufnahmen (29,30) gestattet, wobei im Bereich dieser Überdeckung oberhalb der einen und unterhalb der anderen Substrataufnahme (29 bzw. 30) jeweils ein Stößel (14 bzw. 18) angeordnet ist, die beide parallel der Schwenkachsen (a bzw. b) längsverschiebbar sind und mit Masken (15) zusammenwirken die mit einem Magneten (17) korrespondieren, der an der Substrataufnahme (30) des einen Substrattransportgliedes (7) befestigt ist, wobei die beiden Stößel (14, 18) die Zuführung bzw. die Abnahme und den Transport einer Maske (15, 15',...) von einer Bereitstellungsposition in die Position an der Substrataufnahme (30) oder umgekehrt bewirken.

2. Vorrichtung nach Anspruch 1, dadurch gekennzeichnet, daß die Maske (15) eine etwa hutförmige Konfiguration aufweist und aus magnetischem Werkstoff gefertigt ist und mit ihrer zentralen Sacklochbohrung (32) auf das freie Ende des einen Stößels (14) aufschiebbar ist.

3. Vorrichtung nach Anspruch 2, dadurch gekennzeichnet, daß die hutförmige Maske (15) Bohrungen (31) aufweist über die in die Kammern (3,4) eingelassene Prozeßgase von der einen Seite des Substrats (20) auf die andere Seite des Substrats strömen können, wenn die Maske (15) am Substrat (20) arretiert ist.

4. Vorrichtung nach den Ansprüchen 2 und 3, dadurch gekennzeichnet , daß der in die zentrale Öffnung (25) des Substrats (20) eintauchende topfförmige Teil der Maske (15) auf seiner zylindrischen Außenfläche mit elastisch verformbaren Nocken oder Nasen (28, 28'..) versehen ist, die nach dem Eintauchen das Substrat (20) auf dem topfförmigen Teil halten und zentrieren.

5. Vorrichtung nach einem oder mehreren der Ansprüche 2 bis 4, dadurch gekennzeichnet, daß das freie Ende des einen in die Sacklochbohrung (32) der hutförmigen Maske (15, 15'...) eintauchenden Stößels (14) einen Permanentmagneten (33) bildet.

6. Vorrichtung nach einem oder mehreren der vorhergehenden Ansprüche, dadurch gekennzeichnet, daß die Substrataufnahmen (29) des einen Substrattransportgliedes (6) mit Hilfe elastisch verformbarer Glieder, beispielsweise mit Federarmen (21, 21'...) an der Nabe (8) einer Antriebsweile (10) angeordnet ist, wobei ein am Gehäuse (2) der Anlage parallel zur Schwenkachse (a) verschiebbar gelagertes Druckglied, beispielsweise eine Druckhülse (12), die Substrataufnahme (29) in Richtung auf das in einer parallelen Ebene angeordnete andere Substrattransportglied (7) auslenken kann, bis die eine Substrataufnahme (29) an der Gehäuseinnenwand (23) der einen Kammer (3) anschlägt.

## Claims

1. Apparatus for attaching/removing a mask on a preferably flat circular substrate (7) in a vacuum coating plant comprising two chambers (3, 4) arranged in parallel and joined together via a common aperture (5), wherein in each of the two chambers (3, 4) a substrate conveyor member, a conveyor disk (6, 7) for example, having one substrate seat (29, 30) is pivotably mounted, the pivotal axes (a, b) of these two substrate conveying members being arranged parallel to one another and with the distance between their pivotal axes being such as to permit overlapping of two substrate seats (29, 30) in at least one position, wherein in the region of this overlap a ram (14 and 18 respectively) is provided above one and below the other substrate seat (29 and 30 respectively), the ram being displaceable in the longitudinal direction parallel to the pivotal axes (a and b respectively) and cooperating with masks (15) corresponding to a magnet (17) fixed to the substrate seat (30) of one substrate conveying member (7), wherein the two rams (14, 18) effect the supply or discharge and conveying of a mask (15, 15',...) from a stand-by position into the position on the substrate seat (30) or vice versa.

2. Apparatus according to claim 1, characterised in that the mask (15) has an approximately hat-like configuration, is composed of magnetic material and can be mounted over the free end of one ram (14) with its central blind bore (32).

3. Apparatus according to claim 2, characterised in that the hat-shaped mask (15) has bores (31) through which process gas introduced into the chambers (3, 4) can flow from one side of the substrate (20) to the other side of the substrate when the mask (15) is locked on the substrate (20).

4. Apparatus according to claims 2 and 3, characterised in that the pot-like part of the mask (15a) projecting into the central aperture (25) of the substrate (20) is provided on its cylindrical surface with resiliently deformable cams or lugs (28, 28',..) which after immersion hold and centre the substrate (20) on the pot-like portion.

5. Apparatus according to one or more of claims 2 to 4, characterised in that the free end of the ram projecting into the blind bore (32) of the hat-shaped mask (15, 15,...) forms a permanent magnet (33).

6. Apparatus according to one or more of the preceding claims, characterised in that the substrate seats (29) of one substrate conveying member (6) are disposed on the hub (8) of a drive shaft (10) by means of resilient members, for example with sprung arms (21, 21', ...), wherein a pressure member, e.g. a pressure sleeve (12), displaceably mounted on the housing (2) of the plant parallel to the pivotal axis a) can pivot out the substrate seat (29) in the direction of the other substrate conveying member (7) disposed in a parallel plane until the one substrate support (29) meets with the housing inner wall (23) of the one chamber (3).

## Revendications

1. Dispositif d'application ou d'enlèvement d'un masque sur un substrat plat de préférence de forme circulaire, dans une installation de revêtement sous vide, comportant deux chambres (3, 4) agencées parallèlement l'une à l'autre, qui sont reliées l'une à l'autre par une ouverture (5) commune, des organes de transport des substrats, par exemple des cuillers de transport (6, 7) comportant chacune un logement à substrat (29, 30), étant montés en pivotement dans chacune des deux chambres, les axes de pivotement (a, b) de ces deux organes de transport de substrat étant agencés en parallèle l'un par rapport à l'autre et présentant une distance l'un par rapport à l'autre qui permet dans au moins une position de recouvrir deux logements à substrats (29, 30), un poussoir (14, 18) étant agencé dans la région de ce recouvrement, au-dessus de l'un et au-dessous de l'autre des logements à substrats (29, 30), respectivement, ces deux poussoirs (14, 18) étant déplaçables longitudinalement en parallèle aux axes de pivotement (a, b) respectifs et coopérant avec des masques (15) qui correspondent à un aimant (17) fixé sur le logement à substrat (30) de l'un des organes de transport des substrats (7), les deux poussoirs (14, 18) provoquant l'amenée et la réception, respectivement, et le transport d'un masque (15, 15', ...) depuis une position de mise à disposition jusque dans la position sur le logement à substrat (30) ou inversement.

2. Dispositif selon la revendication 1, caractérisé en ce que le masque (15) a une configuration approximativement en forme de chapeau, est réalisé en matériau magnétique, et susceptible d'être enfilé par son perçage borgne (32) central sur l'extrémité libre de l'un des poussoirs (14).

3. Dispositif selon la revendication 2, caractérisé en ce que le masque (15) en forme de chapeau présente des perçages (31) par l'intermédiaire desquels les gaz de traitement introduits dans les chambres (3, 4) peuvent s'écouler depuis un côté du substrat (20) vers l'autre côté du substrat lorsque le masque (15) est arrêté sur le substrat (20).

4. Dispositif selon les revendications 2 et 3, caractérisé en ce que la partie en forme de pot du masque (15) plongeant dans l'ouverture centrale (25) du substrat (20) est pourvue sur sa surface extérieure cylindrique de saillies ou d'ergots élastiquement déformables (28, 28', ...) qui, après l'introduction, retiennent et centrent le substrat (20) sur la partie en forme de pot.

5. Dispositif selon l'une ou plusieurs des revendications 2 à 4, caractérisé en ce que l'extrémité libre de l'un des poussoirs (14) plongeant dans le perçage borgne (32) du masque (15, 15', ...) en forme de chapeau forme un aimant (33) permanent.

6. Dispositif selon l'une ou plusieurs des revendications précédentes, caractérisé en ce que le logement à substrats (29) de l'un des organes de transport de substrats (6) est agencé à l'aide d'organes élastiquement déformables, par exemple de bras élastiques (21, 21'), sur le moyeu (8) d'un arbre d'entraînement (10), un organe de pression monté en déplacement sur le boîtier (2) de l'installation, parallèlement à l'axe de rotation (a), par exemple une douille de pression (12), étant capable de dévier le logement à substrat (29) en direction de l'autre organe de transport de substrats (7) agencé dans un plan parallèle, jusqu'à ce que l'un des logements à substrats (29) vienne buter contre la paroi intérieure (23) du boîtier de l'une des chambres (3).
